# EUROPÄISCHE PATENTSCHRIFT

(11) **EP 0 691 071 B1**
(45) Veröffentlichungstag und Bekanntmachung des Hinweises auf die Patenterteilung: **23.10.1996**
(21) Anmeldenummer: 94908972.6
(22) Anmeldetag: 07.03.1994
(51) Int. Cl.: H05K 7/20

(54) **BELÜFTUNGSSYSTEM FÜR SCHRÄNKE MIT STARK WÄRMEERZEUGENDEN ELEKTRONISCHEN FUNKTIONSEINHEITEN**
VENTILATION SYSTEM FOR CUBICLES WITH ELECTRONIC FUNCTIONAL UNITS PRODUCING CONSIDERABLE HEAT
SYSTEME D'AERATION D'ARMOIRES A UNITES FONCTIONNELLES ELECTRONIQUES DEGAGEANT BEAUCOUP DE CHALEUR

(30) Priorität: 23.03.1993 DE 4309308
(43) Veröffentlichungstag der Anmeldung: 10.01.1996
(73) Patentinhaber: Siemens Nixdorf Informationssysteme Aktiengesellschaft, 33102 Paderborn (DE)
(72) Erfinder: KNOOP, Franz-Josef, D-33142 Büren-Steinhausen (DE); SCHMIDT, Heinrich, D-33129 Delbrück-Boke (DE)
(74) Vertreter: Fuchs, Franz-Josef, Dr.-Ing.
(86) Internationale Anmeldenummer: DE9400265
(87) Internationale Veröffentlichungsnummer: WO9422285

(56) Entgegenhaltungen:
- US-A- 4 674 004
- US-A- 4 758 925
- US-A- 5 136 464

## Beschreibung

Die Erfindung betrifft ein Belüftungssystem für Schränke mit teilweise mit Lamellen behafteten Türen und mit turmartig übereinander gestapelten Funktionseinheiten, die stark wärmeerzeugende Bauteile enthalten, insbesondere für die Datentechnik.

In Schränken, insbesondere der Datentenchik, sind häufig Funktionseinheiten mit stark wärmeerzeugenden Bauteilen erhalten. Dabei sind die Funktionseinheiten turmartig übereinander angeordnet. Zur Kühlung und zur Abführung der Luft sind für die einzelnen Funktionseinheiten Lüfter vorgesehen, durch die die Warmluft häufig nur an der Deckenseite der Schränke ausgeblasen wird. Häufig ist jedoch auch das Abführen der Warmluft an anderer Stelle erwünscht.

Aus US-A-5 136 464 ist ein Belüftungssystem für beispielsweise in der Datentechnik verwendete Schränke bekannt Die Schränke weisen teilweise mit Lamellen behaftete Seitenteile auf, durch die Luft einströmen kann. Die Schränke weisen ferner turmartig übereinander gestapelte Funktionseinheiten auf, die stark wärmeerzeugend sind. Die Funktionseinheiten sind mechanisch gleich ausgebildet. Sie weisen an der Unterseite Luftablenkbleche auf, die V-förmig angeordnet sind. An der Oberseite sind Lüfter vorgesehen. Die Funktionseinheiten sind in den Schränken in der Weise angeordnet, daß ein Luftspalt zu den den Schrank bildenden Außenwänden vorhanden ist. Durch die Lüfter der Funktionseinheiten wird über zwei durch die V-förmige Anordnung der Luftablenkbleche entstandene V-förmige Schlitze Luft angesaugt, durch die Funktionseinheit gezogen und nach oben abgeblasen. Die von der unteren Funktionseinheit der im Schrank turmartig angeordneten Funktionseinheiten abgeblasene Luft wird dabei durch die V-förmig angeordneten Luftablenkbleche der oberen Funktionseinheit um die obere Funktionseinheit herum geleitet und dann an einem oberen Bereich des Schrankes zusammen mit der von der oberen Funktionseinheit abgeblasenen Luft durch Öffnungen in den Außenwänden des Schrankes ins Freie geleitet. Dabei können die Öffnungen an den Seitenwänden des Schrankes angeordnet sein. In den Öffnungen können ferner zusätzliche Lüfter vorgesehen sein, so daß ein austretender Luftstrom in horizontaler Richtung gegeben ist.

Aufgabe der vorliegenden Erfindung ist es daher, ein Belüftungssystem zu schaffen, das das Austreten der Warmluft in mittiger Höhe eines Schrankes in horizontaler Richtung gestattet.

Zur Lösung dieser Aufgabe wird das Belüftungssystem gemäß der Erfindung derart ausgebildet, daß in mittiger Höhe eines Schrankes vier gleiche Lüfterbaugruppen derart angeordnet sind, daß jeweils zwei Lüfterbaugruppen übereinander und jeweils gegeneinander um 180° gedreht und zwei Lüfterbaugruppen in Gleichlage nebeneinander zu liegen kommen, daß die Lüfterbaugruppen aus einem auf den beiden Längsseiten offenen Lüftergehäuse bestehen, in denen sich mindestens ein Achsial-Radial-Lüfter (Diagonallüfter) befindet, der mit seiner Drehachse senkrecht zur Boden- bzw. Deckfläche des Lüftergehäuses angeordnet ist, daß jeweils zwei übereinander liegende Lüfterbaugruppen abstandslos übereinander liegen, während die beiden anderen Lüfterbaugruppen in einem definierten Abstand voneinander angeordnet sind, so daß zwischen ihnen ein waagrecht verlaufender Luftkanal entsteht und daß die jeweiligen Rück- bzw. Vorderseiten der Lüfterbaugruppen durch Konstruktionselemente des Schrankes abgeschottet sind.

Als abschottendes Konstruktionselement kann dabei ein Teil der Schranktür oder der Rückwand je nach gewünschter Austrittsöffnung der Warmluft verwendet werden. Außerdem können auch im Inneren des Schrankes Traversen oder Abdeckungen für die Abschottungen vorgesehen sein.

Durch diese Maßnahmen wird ein Umlenken des Luftstromes im Schrank von der vertikalen in die horizontale Richtung in einfacher Weise ermöglicht. Die Funktionseinheiten können dadurch optimale belüftet werden, und es wird dadurch die Möglichkeit geschaffen, den Warmluftaustritt an der Rück- oder Vorderseite des jeweiligen Schrankes vorzunehmen.

Die Richtung des Luftaustritts wird in einfacher Weise durch Variation der Einbauplätze der vier Lüfterbaugruppen bestimmt.

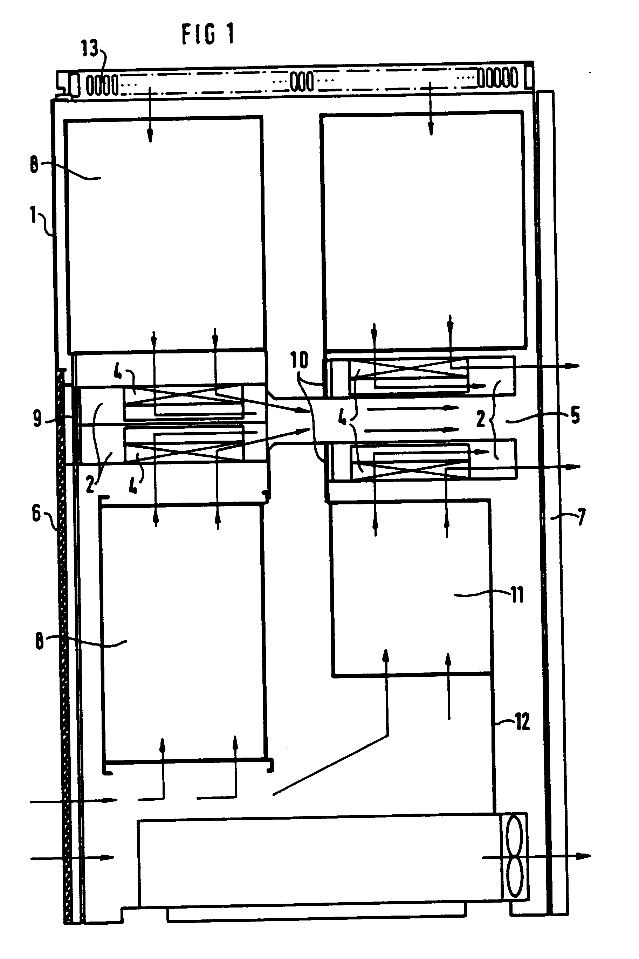

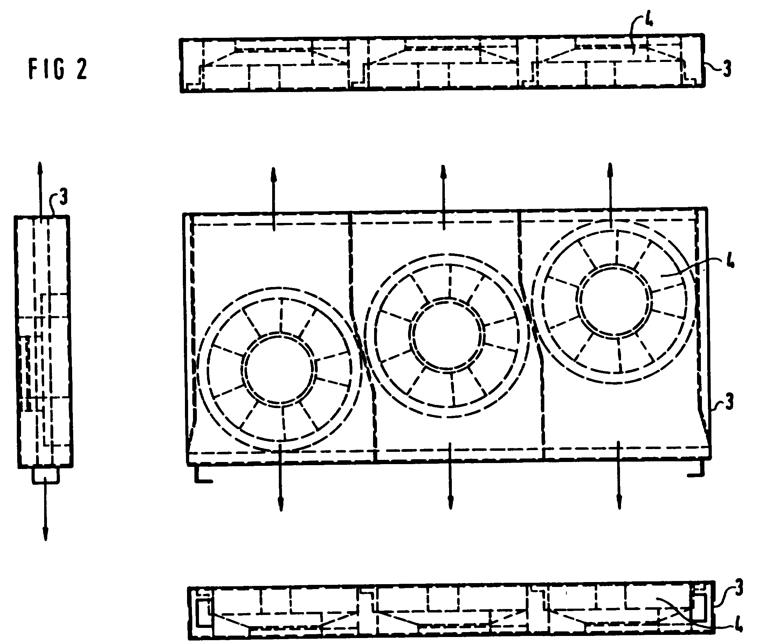

Anhand der Figuren 1 und 2 wird die Erfindung näher erläutert.

Es zeigen
Figur 1 einen Schrank mit turmartig aufgebauten Funktionseinheiten und mittigem Lüftereinbau und
Figur 2 eine Lüfterbaugruppe in Drauf-, Seiten- und Vorderansicht.

Die elektronischen Funktionseinheiten 8 sind, wie in Figur 2 gezeigt, turmartig übereinander in einem Schrank 1 angeordnet. Der Schrank 1 ist an seiner Vorderseite mit einer Türe 6 versehen, die teilweise mit Lamellen zum Luftaustritt behaftet ist. An der Rückseite des Schrankes befindet sich die Abdeckung 7, die ebenfalls luftdurchlässig ausgebildet sein kann.

Vier Lüfterbaugruppen 2 sind etwa in der Mitte des Schrankes 1 angeordnet, so daß sowohl die oberen als auch die unteren Funktionseinheiten des Schrankes gut durchlüftet werden können. Es sind im vorliegenden Fall zwei Säulen von übereinander liegenden Funktionseinheiten 8 vorgesehen. Die Zahl der turmartigen Aufbauten kann jedoch je nach Einsatzfall variieren.

Jeder Säule von Funktionseinheiten 8 sind zwei Lüfterbaugruppen, die übereinander liegen, zugeordnet, wobei bei der fronttürnahen Säule der Funktionseinheiten die untere Lüfterbaugruppe 2 in Bodenlage, die obere in Kopflage eingebaut ist. Bei der zweiten Säule sind die Lüfterbaugruppen 2 übereinander, aber in einem vorgegebenen Abstand voneinander angeordnet, wobei ebenfalls wieder die untere Lüfterbaugruppe in Bodenlage und die obere Lüfterbaugruppe in Kopflage eingebaut ist. Dadurch entsteht ein Luftkanal 5, durch den die von den beiden vorderen Lüfterbaugruppen abgeführte Luft auf der Rückseite des Schrankes abziehen kann, während die von den beiden rückseitigen Lüfterbaugruppen angesaugte Luft unmittelbar aus der Lüfterbaugruppe waagrecht austretend auf der Rückseite abführbar ist. Alle vier Lüfterbaugruppen sind an ihren hinteren Seiten offen, während sie jeweils an ihren vorderen Seiten abgeschottet sind. Die Abschottung 9 der vorderen Seiten der fronttürseitigen Lüfterbaugruppen 2 erfolgt über die Schranktüre 6, während die Abschottung der Vorderseiten der rückseitig eingebauten Lüfterbaugruppen 2 durch in den Schrank eingesetzte Traversen 10 vorgenommen wird. Da die hintere Säule in ihrem unteren Bereich eine Funktionseinheit 11 aufweist, die nicht in ihrer vollen Länge den vorgesehenen Schrankplatz ausfüllt, ist an dieser Stelle eine weitere Abschottung in Form einer Abdeckung 12 vorgesehen, um zu vermeiden, daß die an der Unterseite des Schrankes angesaugte Luft in einem Fehlkanal an der Funktionseinheit 11 vorbei wirkungslos abfließen würde. Der Ansaugbereich für die im Schrank oben angeordneten Funktionseinheiten erfolgt über das ebenfalls lamellisierte Deckblech, während der Ansaugbereich für die im unteren Teil des Schrankes 1 sich befindenden Funktionseinheiten über den unteren Teilbereich der mit Lamellen versehenen Türe 6 erfolgt.

Wie in Figur 2 dargestellt, befinden sich in einer Lüfterbaugruppe 2 jeweils drei Achsial-Radial-Lüfter 4. Die Längsseiten des Lüftergehäuses sind dabei offen, während die Schmalseiten geschlossen sind. Die Luft tritt an den beiden offenen Längsseiten der Lüfterbaugruppe 2 aus. Durch Verschließen einer der Längsseiten kann der Luftaustritt jeweils auf die andere Längsseite verlagert werden.

## Patentansprüche

1. Belüftungssystem für Schränke mit teilweise mit Lamellen behafteten Türen und mit turmartig übereinander gestapelten Funktionseinheiten (8,11), die stark wärmeerzeugende Bauteile enthalten, insbesondere für die Datentechnik,
**dadurch gekennzeichnet**,
daß in mittiger Höhe eines Schrankes (1) vier gleiche Lüfterbaugruppen (2) derart angeordnet sind, daß jeweils zwei Lüfterbaugruppen (2) übereinander und jeweils gegeneinander um 180° gedreht und zwei Lüfterbaugruppen (2) in Gleichlage nebeneinander zu liegen kommen, daß die Lüfterbaugruppen aus einem auf den beiden Längsseiten offenen Lüftergehäuse (3) bestehen, in denen sich mindestens ein Achsial-Radial-Lüfter (4) befindet, der mit seiner Drehachse senkrecht zur Boden- bzw. Deckfläche des Lüftergehäuses (3) angeordnet ist, daß jeweils zwei übereinander liegende Lüfterbaugruppen (2) abstandslos übereinander liegen, während die beiden anderen Lüfterbaugruppen (2) in einem definierten Abstand voneinander angeordnet sind, so daß zwischen ihnen ein waagrecht verlaufender Luftkanal (5) ansteht und daß die jeweiligen Rück- bzw. Vorderseiten der Lüfterbaugruppen durch Konstruktionselemente des Schrankes abgeschottet sind.

2. Belüftungssystem für Schränke nach Anspruch 1,
**dadurch gekennzeichnet**,
daß als abschottendes Konstruktionselement ein Teil der Schranktür (6) oder der Rückwand (7) dient.

3. Belüftungssystem für Schränke nach Anspruch 1 oder 2,
**dadurch gekennzeichnet,**
daß die Abschottungen aus Traversen (10) oder Abdeckungen (12) im Schrank bestehen.

## Claims

1. Ventilation system for cabinets with doors partly equipped with louvres and with functional units (8, 11) stacked, tower fashion, one above another and containing components which produce considerable heat, especially for data processing, characterized in that four identical fan units (2) are arranged half-way up a cabinet (1) in such a manner that in each case two fan units (2) lie one above the other and each rotated with respect to the other through 180° and two fan units (2) lie in an identical position next to each other, in that the fan units comprise a fan housing (3) which is open on the two longitudinal sides and in which there is at least one axial-radial fan (4) which is arranged with its axis of rotation perpendicular with respect to the bottom surface and top surface of the fan housing (3), in that in each case two fan units (2), which lie one above the other, lie directly one above the other, whereas the two other fan units (2) are arranged at a defined distance apart thus forming a horizontal air duct (5) between them, and in that the respective backs or fronts of the fan units are partitioned off by structural elements of the cabinets.

2. Ventilation system for cabinets according to Claim 1, characterized in that part of the cabinet door (6) or of the back wall (7) serves as the partitioning structural element.

3. Ventilation system for cabinets according to Claim 1 or 2, characterized in that the partitions comprise cross-members (10) or covers (12) in the cabinet.

## Revendications

1. Système de ventilation pour des armoires comportant des portes partiellement équipées de lamelles et des unités fonctionnelles (8, 11) empilées les unes au-dessus des autres en forme de tour, qui contiennent des composants dégageant beaucoup de chaleur, destinés notamment à la technique de traitement des données,
caractérisé par le fait que,
quatre groupes de ventilateurs (2) identiques sont disposés à mi-hauteur d'une armoire (1), de telle sorte que deux groupes de ventilateurs (2) soient respectivement superposés et tournés de 180° l'un par rapport à l'autre, et que deux groupes de ventilateurs (2) soient situés dans la même position l'un à côté de l'autre, que les groupes de ventilateurs sont constitués d'un carter (3) de ventilateur ouvert sur les deux côtés longitudinaux, dans lesquels se trouve au moins un ventilateur axial-radial (4) dont l'axe de rotation est disposé perpendiculairement à la surface de fond ou de couverture du carter (3) de ventilateur, que deux groupes de ventilateurs (2) superposés sont respectivement superposés sans écartement, alors que les deux autres groupes de ventilateurs (2) sont disposés à un écartement défini l'un par rapport à l'autre, de façon à former un canal d'aération horizontal (5) entre eux, et que les faces arrière et avant respectives des groupes de ventilateurs sont cloisonnées par des éléments de construction de l'armoire.

2. Système de ventilation pour des armoires selon la revendication 1,
caractérisé par la fait que,
une partie de la porte (6) de l'armoire ou de la paroi arrière (7) sert d'élément de construction de cloisonnement.

3. Système de ventilation pour des armoires selon la revendication 1 ou 2,
caractérisé par la fait que,
les cloisonnements sont constitués de traverses (10) ou de recouvrements (12) se trouvant dans l'armoire.
